# EUROPEAN PATENT APPLICATION

(11) **EP 0 805 459 A1**
(43) Date of publication of application: **05.11.1997**
(21) Application number: 97107087.5
(22) Date of filing: 29.04.1997
(51) Int. Cl.: G11C 29/00

(54) **Method and apparatus for testing DRAM memory units**

(30) Priority: 30.04.1996 US 17077
(71) Applicant: TEXAS INSTRUMENTS INCORPORATED, Dallas Texas 75265 (US)
(72) Inventor: Hii, Kuong Hua, Singapore 809690 (SG); Cline, Danny R., Plano, Texas 75094 (US); Looi, Choon P., No. 04-578, Singapore 510474 (SG); Chng, Kheng H., Singapore 523230 (SG)
(74) Representative: Schwepfinger, Karl-Heinz, Dipl.-Ing.

(57) **Abstract**

In a dynamic random access memory unit, a built-in-self-test unit, in response to an activation signal, provides sequences of signals for storage in the storage cell array, retrieves the signals from the storage cell array, and compares the stored signals with the retrieved signals to verify the operation of the memory unit. The activation signal is generated when an overvoltage detection unit detects an overvoltage of a selected memory unit terminal. The built-in-self-test unit includes a local memory unit for storing the sequence of signals controlling the test procedures. Portions of the test sequence can be selected by DC applied to the built-in-self-test unit through terminals of the memory unit.

## Description

This invention relates generally to semiconductor memory units and, more particularly, to a method for testing semiconductor memory units.

### DESCRIPTION OF THE RELATED ART

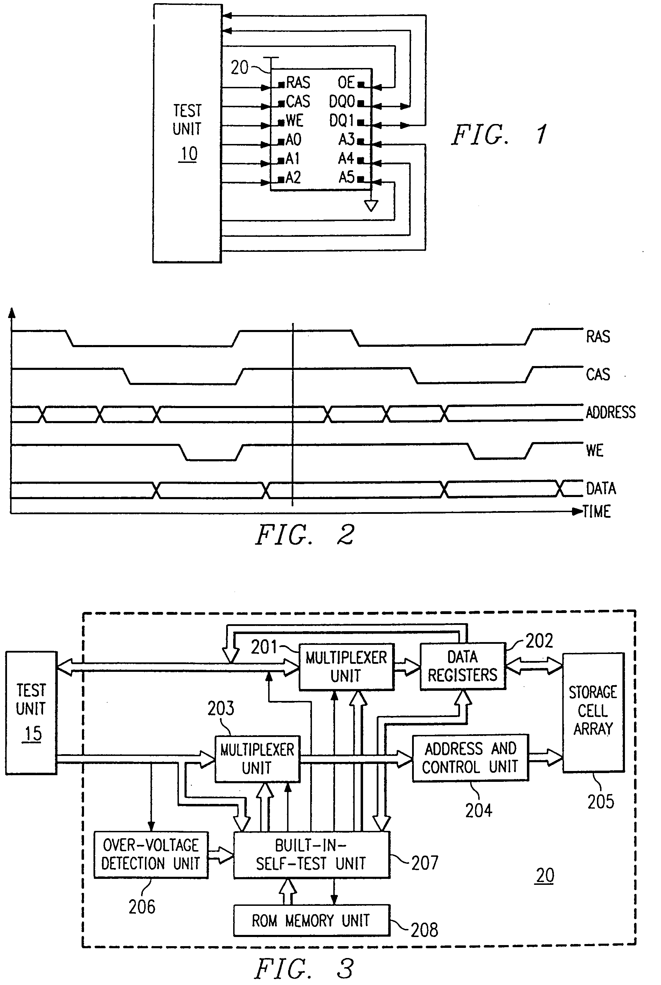

Referring to Fig. 1, a conventional arrangement method for the testing of dynamic random access memory units 20 is shown. The signals from the test unit 10 are applied to the device (DRAM memory unit 20) under test. The data signals DQ0-DQ1, address signals A0-A5, row address signal RAS, column address signal CAS, write enable WE, and operation enable signal OE are examples of signals that are typically applied to the device under test. The conducting leads, over which data signals DQ0 and DQ1 are applied to the device under test, are also used to communicate the results of the test procedures, i.e., pass or fail, to the test unit 10. Fig. 2 illustrates the time dependence of typical signals applied by the test unit 10 to the device 20 under test. These signals are frequently periodic clock signals.

The length of time required to test the memory unit has increased in proportion to the number of storage cells which must be tested. Thus, the testing procedures can impact the cost and manufacturing time. To reduce the average test time and reduce the number of test units 10 required, memory units 20 can be tested in parallel. However, because of the high frequency of the signals that are required to test the memory units 20, capacitance loading reduces the extent to which memory units 20 can be tested in parallel in the configuration shown in Fig. 1.

A need has therefore been felt for apparatus and a associated procedure for testing memory units which permits multiple memory units to be tested simultaneously. More particularly, a need has been felt for apparatus and an associated procedure in which a test unit tests a memory unit using only DC signals, thereby minimizing the effects of parasitic capacitance on signal degradation.

### SUMMARY OF THE INVENTION

The aforementioned and other features are accomplished, according to the present invention, by including as a part of the semiconductor memory unit chip built-in-self-test (BIST) unit. The built-in-self-test unit has the ability to exercise the components of the semiconductor chip by internally generating predetermined groups of data signals and predetermined address and control signals. To initiate the operation of the BIST unit, a detection circuit identifies an (DC) overvoltage, generated by a test unit, on a preselected memory unit terminal and places the device in a BIST test mode. In the BIST test mode, DC signals applied to preselected input terminals control the operation of the built-in-self-test unit by determining which test procedure is to be executed. The BIST unit stores and retrieves data signals and compares the retrieved data signals with the originally stored data signals. After the comparison has been completed for the test procedure or procedures, the result are communicated externally by data signals paths. The overvoltage and the DC control signals are all steady state signals, the high frequency test data, address, and control signals being generated by the built-in-self-test unit.

These and other features of the present invention will be understood upon the reading of the following description in conjunction with the Figures.

### BRIEF DESCRIPTION OF THE DRAWINGS

Figure 1 is a block diagram illustrating electrical connections between a testing unit and a memory unit under test according to the prior art;
Figure 2 is a timing diagram of typical signals applied by a testing unit to a memory unit under test;
Figure 3 is schematic block diagram of the circuit components of a memory unit according to the present invention;
Figure 4 is a block diagram of memory units and conducting leads on a tester board according to the present invention;
Figure 5 is a perspective view of a test chamber for testing a plurality of memory units according to the present invention; and
Figure 6 is a schematic diagram of the energizing board for applying power to the test boards of Fig. 4 according to the present invention.

### DETAILED DESCRIPTION OF THE DRAWINGS

Fig. 1, and Fig. 2 have been described with respect to the related art.

Referring next to Fig. 3, a dynamic random access memory unit 20 to be tested is shown. The memory unit 20 includes a multiplexer unit 201 which receives data signals from a test unit 15 and applies data signals to the data registers 202. The data registers 202 exchange data signals with the storage cell array 205. The multiplexer 203 receives address and control signals from the test unit 15 and applies address and control signals to the address and control unit 204. The address and control unit 204 applies signals to the storage cell array 205. The overvoltage detection unit 206 receives a signal from an address signal memory unit terminal (in the preferred embodiment) and applies an initiation signal to the built-in-self-test unit 207. The built-in-self-test unit 207 receives signals from address signal memory unit terminals, from the data registers 202, and exchanges signals with the ROM memory unit 208. The built-in-self-test unit 207 applies signals to the control terminals and to the input terminals of multiplexer units 201 and 202 and applies a status signal to a memory unit data terminal. Signals from the data registers 202 are applied to selected data signal input/output terminals of memory unit 20 to communicate the results of the test procedure(s).

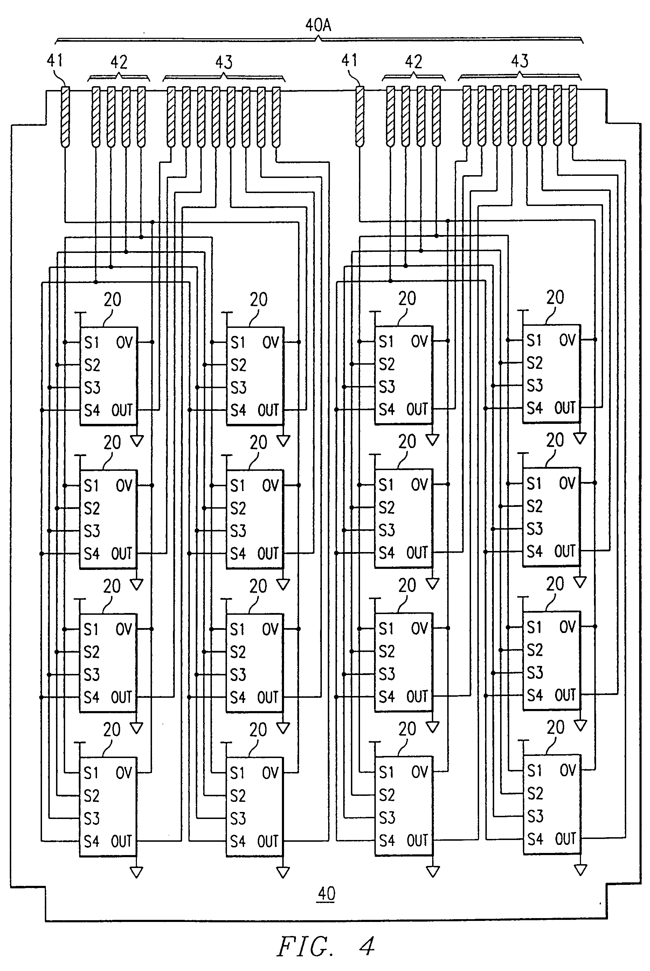

Referring to Fig. 4, an arrangement for testing memory units 20 according to the present invention is shown. A plurality of memory units 20 are mounted on a test board 40 and electrically coupled to conducting leads 41-43. The conducting leads terminate on a connector region 40A of the test board 40. The overvoltage signal is applied to the memory units 20 via conducing leads 41. The control signals, which control the internal test procedures stored in ROM memory unit 208, are applied to the memory units 20 via conducting leads 42. The results of the test procedures are applied by the memory units 20 to conducting leads 43.

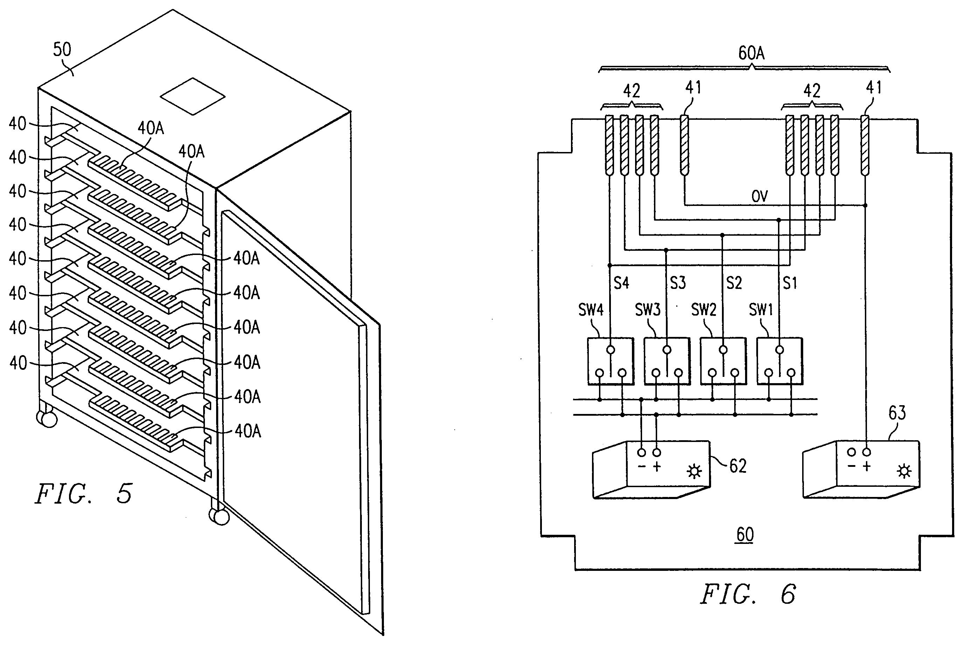

Referring to Fig. 5, the positioning of a plurality of test boards 40 in a test chamber 50 is shown. The connector portions 40A of the test boards 40 are positioned to be accessible to a connector (not shown).

Referring to Fig. 6, a circuit diagram for the voltage source board 60 which energized the connector (not shown) and consequently the test boards, according to the present invention, is shown. The connector portion 60A of the voltage source board 60 includes the energizing conductors for the overvoltage source 41 and for the control signal sources 42. The overvoltage conductors 41 are coupled to supply (typically an AC-DC converter unit) 63. The control signal conductors 42 (S1-S4) are coupled through switches SW1-SW4 to supply (typically an AC-DC converter unit) 62. The position of the switches SW1-SW4 control the voltages (i.e., the logic states) applied to selected terminals of the memory unit and consequently control the test procedure or procedures executed in the memory unit 20.

The operation of the present invention can be understood as follows. In the ordinary mode of operation of the memory unit 20, data signals are transferred through the multiplexer unit 201 to the data registers 202. The data signals are then exchanged with the storage cell array 205. The data signals are entered into the storage cell array 205 during a write operation and retrieved from the storage cell array during the read operations. Similarly, the address and control signals are applied to the multiplexer unit 203 and then applied to the address and control unit 204. The address and control signal unit 204 applies signals to the storage cell array 205. These signals determine the location in the storage cell array 205 being accessed and the operation being performed. In order for the memory unit to enter the BIST test mode, an overvoltage signal is applied to one of the memory unit 20 terminals. (In the present embodiment, the overvoltage signal is applied to an address terminal A4.) The overvoltage detection unit 206 identifies the presence of an overvoltage applied to the memory unit 20 terminal and applies a control signal to the built-in-self-test unit 207. In response to this control signal, operation of the built-in-self-test unit 207 is initiated and signals are applied to the multiplexer units 201 and 203. In response to these control signals, external data. address, and control signals are prevented from providing the functions associated with typical memory operations. Instead, data, address, and control signals which originate in the built-in-self-test unit 207 are transmitted through the multiplexer units 201 and 203. The initiation of the operation of the built-in-self-test unit results in the retrieval of a sequence of signals stored in the ROM memory unit 208. Based on the signals retrieved from the ROM memory unit 208, the data, address, and control signals are generated which are transmitted through the multiplexer units 201 and 203 and which duplicate the normal operation of the memory unit 20. Data signals are stored in the storage cell array 205 and retrieved therefrom and stored in the data registers 202. From the data registers 202, the retrieved data signals are applied to the built-in-self-test unit 207. In the built-in-self-test unit 207, the retrieved signals are compared with the data signals originally stored in storage cell array 205. The originally stored signals are once again retrieved from the ROM memory unit 208. When the comparison of the stored and the associated retrieved signals are the same, then operation of the memory unit 20 is acceptable. This information is transmitted by a signal (or signals) applied to a data signal terminal (or terminals). When the overvoltage is removed, the operation of the built-in-self-test unit 207 is halted and the memory unit 20 is ready for normal operation.

The memory unit 20 of the present invention overcomes the problems in testing of the prior art. As indicated in Fig. 4, a multiplicity of memory units 20 can be tested simultaneously. Because the overvoltage and the control signals are DC signals, the generation and distribution of these signals is relatively simple. All that is needed, in addition to a supply and a ground voltage source, are an overvoltage supply source and a DC signal source with switches for providing determining the voltage levels, i.e., the logic states, of the procedure-identifying control signals. These control signals determine the test procedures executed simultaneously by the memory units being tested.

The foregoing operation can be made flexible in the following manner. When the built-in-self-test unit 208 is in the test mode, then the state of signals applied to the address signal terminals can be used to select from a plurality of test modes. For example, one test mode may be to exercise a selected portion of the memory unit (storage cell array 205) and communicate the result of this test procedure to the test unit 15.

The invention has been described with particular reference to the preferred embodiment, it will be under stood by those skilled in the art that various changes may be made and equivalents substituted for elements of the preferred embodiment without departing from the invention. In addition, many modifications may be made to adapt a particular situation and material to a teaching of the present invention without departing from the essential teachings of the present invention.

As is evident from the foregoing discussion, certain aspects of the invention are not limited to the particular details of the examples illustrated, and it is therefore contemplated that other modifications and applications will occur to those skilled in the art. It is accordingly intended that the claims shall cover all modifications and applications as do not depart from the spirit and scope of the invention.

## Claims

1. A dynamic random access memory unit, said memory unit comprising:
a semiconductor memory unit; and
a built-in-self-test unit for testing said semiconductor memory unit, said built-in-self-test unit activated by a DC overvoltage signal applied to a selected terminal of said dynamic random access unit, said built-in-self-test unit comparing data signals retrieved from selected locations in said semiconductor memory unit with data signals originally stored in the selected locations of said semiconductor memory unit, said built-in-self-test unit supplying an external signal indicative of results of said comparing data signals.

2. The dynamic random access memory unit of claim 1 wherein said built-in self-test unit is activated during a power-up procedure by said overvoltage signal.

3. The dynamic random access memory unit of claim 1 wherein DC voltages applied to said built-in-self-test unit through selected terminals of said dynamic random access memory unit.

4. Test apparatus for testing dynamic random access memory units, said apparatus comprising:
a first supply providing a DC overvoltage;
at least one first conducting lead for coupling a said first supply to a selected terminal of a dynamic random access memory unit under test; and
at least one second conducting lead coupled to a first selected terminal of a coupled dynamic random access memory unit, said second conducting lead receiving from a coupled memory unit a result signal.

5. The test apparatus of Claim 4 wherein said DC overvoltage is activates a test procedure in said memory unit under test.

6. The test apparatus of Claim 5 wherein said DC overvoltage activates said test procedure during power-up of said memory unit.

7. The test apparatus of Claim 4 further comprising:
a second DC supply;
at least one conducting lead coupling said second DC supply to a memory unit under test;
at least one third conducting lead for coupling said second DC supply to a second selected terminal of said memory unit under test; and
a switch coupled between said second DC supply and a second selected terminal of said memory unit under test for determining which terminal of said DC supply is coupled to said selected second terminal.

8. A method for testing a dynamic random access memory unit, said method comprising the steps of:
activating a built-in-self test unit portion of said memory unit by a DC overvoltage signal; and
de-activating said built-in-self-test unit when DC overvoltage signal is removed.

9. The method of Claim 8 wherein said activating step includes the step of activating said built-in-self-test unit during power up of said memory unit.

10. The method of Claim 8 further comprising the step of:
selecting one of a plurality of test procedures by applying at least one DC signal to said memory unit when said built-in-self-test unit is activated.

11. A dynamic random access memory unit adapted to be testing by having only DC signals applied thereto, said memory unit comprising:
a semiconductor memory portion;
a built-in-self-test portion, said built-in-self-test portion having a inactive mode and a test mode, wherein said built-in-self-test portion verifies operation of said semiconductor memory portion in said test mode, said built-in-self-test portion entering in said test mode in response to an activation signal; and
an overvoltage detection unit for providing said activation signal in response to an application of a DC overvoltage to selected terminal of said semiconductor memory portion.

12. The memory unit of Claim 11 wherein said overvoltage detection unit provides said activation upon application of said DC overvoltage to said selected terminal during a power-up of said dynamic random access memory unit.

13. The memory unit of Claim 11 wherein said built-in-self-test unit is responsive to at least one DC control signal, said DC control signals specifying one of a plurality of test procedures when said built-in-self-test portion is in said test mode.

14. The memory unit of Claim 11 wherein non-test signals are prevented from interacting with said semiconductor memory in said test mode.
